# EUROPÄISCHE PATENTSCHRIFT

(11) **EP 2 823 324 B1**
(45) Veröffentlichungstag und Bekanntmachung des Hinweises auf die Patenterteilung: **25.05.2016**
(21) Anmeldenummer: 13708097.4
(22) Anmeldetag: 07.03.2013
(51) Int. Cl.: G01R 31/319, G01R 1/067, G01R 3/00

(54) **VORRICHTUNG ZUR MESSUNG ELEKTRONISCHER BAUTEILE**
DEVICE FOR MEASURING ELECTRONIC COMPONENTS
DISPOSITIF POUR MESURER DES COMPOSANTS ÉLECTRONIQUES

(30) Priorität: 08.03.2012 DE 202012002391 U
(43) Veröffentlichungstag der Anmeldung: 14.01.2015
(73) Patentinhaber: Rosenberger Hochfrequenztechnik GmbH & Co. KG, 83413 Fridolfing (DE)
(72) Erfinder: NEUHAUSER, Roland, 83413 Fridolfing (DE)
(74) Vertreter: Zeitler Volpert Kandlbinder Patent- und Rechtsanwälte Partnerschaft mbB
(86) Internationale Anmeldenummer: PCT/EP2013/000674
(87) Internationale Veröffentlichungsnummer: WO 2013/131651

(56) Entgegenhaltungen:
- JP-A- 2004 085 377
- US-A1- 2009 128 171
- US-B1- 6 724 209

## Beschreibung

Die Erfindung betrifft eine Vorrichtung zur Messung elektronischer Bauteile mit einer Mehrzahl von auf einem dielektrischen Leitungsträger aufgebrachten Leitern, die jeweils mit einem Kontaktfinger sowie mit einem Anschlusskontakt verbunden sind.

Eine gattungsgemäße Vorrichtung in Form einer sogenannten Messspitze ist beispielsweise aus der DE 199 45 178 C2 bekannt. Solche Messspitzen werden beispielsweise zum Testen der Funktionsfähigkeit und der elektrischen Eigenschaften von auf Wafern ausgebildeten elektronischen Schaltungen eingesetzt, wozu diese über die Anschlusskontakte mit einer geeigneten Messvorrichtung verbunden sind. Dabei wird die Messspitze so auf dem Wafer aufgesetzt, dass deren Kontaktfinger die Leiterbahnen an definierten Stellen kontaktieren.

Bekannt ist, derartige Messspitzen mit einer Vielzahl von Kontaktfingern auszubilden, die jeweils für einen Kontakt an einer unterschiedlichen Kontaktstelle des zu testenden elektronischen Bauteils vorgesehen sind, und die über jeweils einen Leiter mit einem dazugehörigen Anschlusskontakt verbunden sind ("Mehrkontakt-Messspitzen"). Für jeden dieser Einzelkontakte der Messspitze können - in Abhängigkeit von dem Kontaktlayout des zu testenden elektronischen Bauteils - die Pfade der darüber geleiteten elektrischen Energie oder der darüber geleiteten Signale unterschiedlich sein.

Bei den bekannten Mehrkontakt-Messspitzen ist die Funktion bzw. der Pfad für die elektrische Energie bzw. die Signale jedes Einzelkontakts an das Kontaktlayout des zu testenden elektronischen Bauteils angepasst. Zum Testen eines Bauteils mit einem anderen Kontaktlayout muss daher eine neue, daran angepasste Messspitze hergestellt werden.

Bekannt ist, insgesamt drei unterschiedliche Pfade vorzusehen, wobei als ein erster Pfad eine direkte bzw. ausschließliche Verbindung zwischen dem Kontaktfinger und dem dazugehörigen Anschlusskontakt vorgesehen ist. Ein anderer, zweiter Pfad kann vorsehen, den einen Kontaktfinger mit einem Anschlusskontakt verbindenden Leiter zusätzlich mit einem Anschluss an Masse zu versehen. Bei dem dritten Pfad erfolgt der Anschluss an Masse über Pufferelemente, wie insbesondere einen Kondensator und einen ohmschen Widerstand. So offenbart US 2009/0128171 eine Probecard zum Testen von der Mikrostrukturen (z.B. MEMS). Die Probecard wird zwichen den Elektroden-Pads und einer Messeinheit eingesetzt, wobei die Probecardleiter durch die relais entweder mit einem Probe-Kontroller oder mit der Messeinheit verbunden werden konnen. Der Probecontroller kann die Leiter entweder mit der Versorgungsspannung der mit der Masse verbinden.

Ausgehend von diesem Stand der Technik lag der Erfindung die Aufgabe zugrunde, den Aufwand zum Testen von elektronischen Bauteilen mit unterschiedlichem Kontaktlayout zu verringern.

Diese Aufgabe wird durch eine Vorrichtung gemäß dem unabhängigen Anspruch 1 gelöst. Vorteilhafte Ausgestaltungen der erfindungsgemäßen Vorrichtung sind Gegenstand der abhängigen Ansprüche und ergeben sich aus der nachfolgenden Beschreibung der Erfindung.

Der Erfindung liegt der Gedanke zugrunde, eine gattungsgemäße Vorrichtung zur Messung von elektronischen Bauteilen (eine Mehrkontakt-Messspitze) dadurch flexibler auszugestalten, dass die Funktion zumindest eines, vorzugsweise jedoch jedes Einzelkontakts der Vorrichtung durch eine Veränderbarkeit des Pfads für die darüber geleitete elektrische Energie bzw. die Signale veränderbar ist. Dies ermöglicht, die Vorrichtung zum Testen von einer Vielzahl von elektronischen Bauteilen mit unterschiedlichem Kontaktlayout zu verwenden. Hierzu muss lediglich die Funktion der Einzelkontakte an das jeweilige Kontaktlayout des zu testenden elektronischen Bauteils angepasst werden.

Eine gattungsgemäße Vorrichtung zur Messung elektronischer Bauteile, die eine Mehrzahl von auf einem dielektrischen Leitungsträger aufgebrachte Leitungen umfasst, die jeweils mit einem Kontaktfinger sowie mit einem Anschlusskontakt verbunden sind, ist demnach erfindungsgemäß dadurch gekennzeichnet, dass in zumindest einen, vorzugsweise alle der Leiter ein (vorzugsweise mechanischer) Schalter integriert ist, über den der dazugehörige Leiter zusätzlich mit einem Masseanschluss verbindbar ist. Dabei kann vorzugsweise vorgesehen sein, dass die Verbindung mit dem Masseanschluss entweder direkt oder über mindestens ein Pufferelement erfolgt.

Besonders bevorzugt ist vorgesehen, dass der Schalter mindestens drei Schaltstellungen aufweist, wobei der dazugehörige Leiter in einer ersten Schaltstellung nicht mit einem Masseanschluss verbunden ist, in einer zweiten Schaltstellung direkt mit dem Masseanschluss verbunden ist und in einer dritten Schaltstellung über mindestens ein Pufferelement mit dem Masseanschluss verbunden ist. Dadurch besteht die Möglichkeit, für jeden der Einzelkontakte die bei der Prüfung elektronischer Bauteile relevante Funktion zu übernehmen, wodurch die Flexibilität zur Anpassung an unterschiedlichen Kontaktlayouts der zu messenden elektronischen Bauteile besonders groß ist.

Vorzugsweise umfasst das Pufferelement (zumindest) eine Kapazität (insbesondere einen Kondensator) sowie (mindestens) einen ohmschen Widerstand.

Die erfindungsgemäße Vorrichtung wird im Folgenden anhand eines in den Zeichnungen dargestellten Ausführungsbeispiels näher erläutert. In den Zeichnungen zeigt:
- Fig. 1:: eine erfindungsgemäße Vorrichtung in einer Draufsicht; und
- Fig. 2:: in einer schematischen Darstellung die möglichen Schaltstellungen jedes Einzelkontakts der erfindungsgemäßen Vorrichtung gemäß der Fig. 1 und die sich daraus ergebenden Pfade.

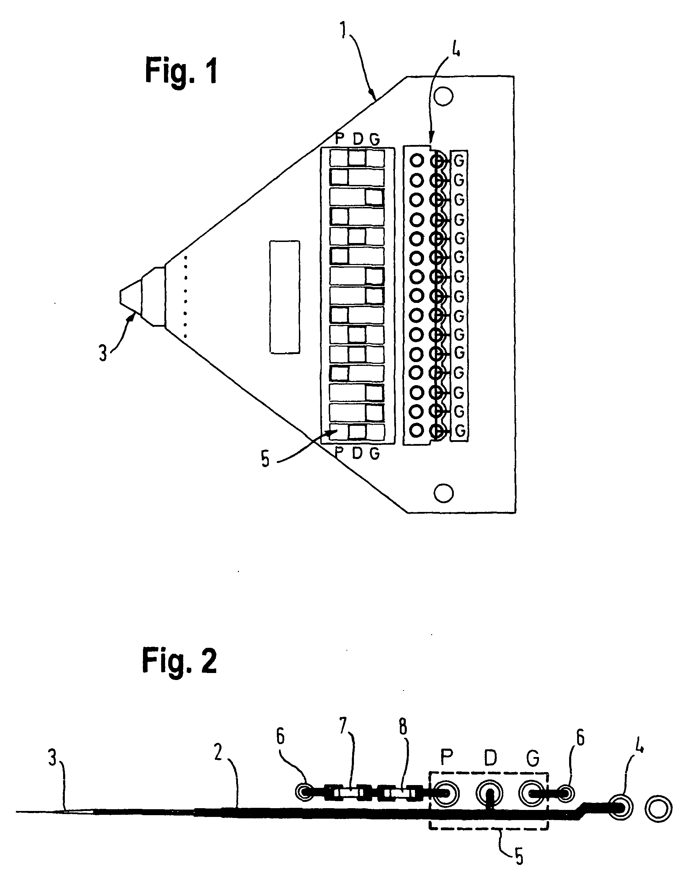

Die erfindungsgemäße Vorrichtung gemäß der Fig. 1 umfasst einen dielektrischen Leitungsträger 1, auf dessen Unterseite eine Mehrzahl von Leitern 2 in Form von Leiterbahnen aufgebracht sind. Diese Leiterbahnen sind beabstandet voneinander angeordnet und damit elektrisch voneinander isoliert. Jeder der Leiter 2 ist - zur Ausbildung eines Einzelkontakts - zum einem mit einem (federnden) Kontaktfinger 3 aus einem elektrisch leitfähigen Material verbunden. Die Kontaktfinger 3, die für eine Kontaktierung von Leiterbahnen oder anderen elektrischen Komponenten auf einem zu testenden elektronischen Bauteil (nicht dargestellt) vorgesehen sind, überragen den Leitungsträger 1 und enden im Wesentlichen auf einer Linie. Weiterhin ist jeder der Leiter 2 mit einem Anschlusskontakt 4 in Form eines sogenannten DC-Pins verbunden. Über diese Anschlusskontakte 4 wird die Vorrichtung mit einer Messvorrichtung (nicht dargestellt) verbunden.

Erfindungsgemäß ist in jeden der Leiter 2 ein Schalter 5 (konventioneller Miniaturschalter) integriert. Jeder dieser Schalter 5 weist drei alternative Schaltstellungen auf. In einer ersten Schaltstellung, in den Fig. 1 und 2 mit "D" bezeichnet, liegt eine direkte bzw. ausschließliche elektrische Verbindung zwischen dem jeweiligen Kontaktfinger 3 und dem dazugehörigen Anschlusskontakt 4 vor. Werden die Schalter 5 in die in den Fig. 1 und 2 mit "G" bezeichnete (zweite) Schaltstellung verschoben, so ist zusätzlich eine Verbindung mit einem Masseanschluss 6 hergestellt. Bei der in den Fig. 1 und 2 mit "P" bezeichneten Schaltstellung ist ebenfalls eine zusätzliche Verbindung mit einem Masseanschluss 6 vorgesehen, dieser erfolgt jedoch unter Zwischenschaltung eines Pufferelements. Dieses Pufferelement umfasst einen (vorzugsweise fest definierten) Kondensator 7 (z.B. 10 nF) und einen (vorzugsweise fest definierten) ohmschen Widerstand 8 (z.B. 2,2 Ω).

In Abhängigkeit von dem Kontaktlayout des zu testenden elektronischen Bauteils können die Vielzahl von Schaltern 5 jeweils so geschaltet werden, dass für jeden der Einzelkontakte ein an das Kontaktlayout angepasster Pfad eingestellt werden.

## Patentansprüche

1. Vorrichtung zur Messung elektronischer Bauteile mit einer Mehrzahl von auf einem dielektrischen Leitungsträger (1) aufgebrachten Leitern (2), die jeweils zum einen mit einem Kontaktfinger (3) und zum anderen mit einem Anschlusskontakt (4) zum Verbinden mit einer Messvorrichtung verbunden sind, **dadurch gekennzeichnet, dass** in zumindest einen der Leiter (2) ein Schalter (5) integriert ist, über den der einen Kontaktfinger mit einem Anschlusskontakt verbindende Leiter (2) zwischen dem Kontaktfinger und dem Anschlusskontakt zusätzlich mit einem Masseanschluss (6) verbindbar ist.

2. Vorrichtung gemäß Anspruch 1, **dadurch gekennzeichnet, dass** jeder der Leiter (2) über jeweils einen Schalter (5) mit einem Masseanschluss (6) verbindbar ist.

3. Vorrichtung gemäß Anspruch 1 oder 2, **dadurch gekennzeichnet, dass** die Verbindung mit dem Masseanschluss (6) über mindestens ein Pufferelement erfolgt.

4. Vorrichtung gemäß einem der vorhergehenden Ansprüche, **dadurch gekennzeichnet, dass** der Schalter (5) mindestens drei Schaltstellungen aufweist, wobei der dazugehörige Leiter (2)
- in einer ersten Schaltstellung nicht mit einem Masseanschluss (6) verbunden ist;
- in einer zweiten Schaltstellung direkt mit dem Masseanschluss (6) verbunden ist; und
- in einer dritten Schaltstellung über mindestens ein Pufferelement mit dem Masseanschluss (6) verbunden ist.

5. Vorrichtung gemäß Anspruch 3 oder 4, **dadurch gekennzeichnet, dass** das Pufferelement einen Kondensator (7) und einen ohmschen Widerstand (8) umfasst.

## Claims

1. Device for measuring electronic components, having a plurality of conductors (2) applied to a dielectric conductor carrier (1), which conductors (2) are each connected on the one hand to a contact finger (3) and on the other hand to a connecting contact (4) for connection to a measuring device, **characterised in that** a switch (5) is incorporated in at least one of the conductors (2), via which the conductor (2) between a contact finger and a connecting contact, which conductor (2) connects the contact finger and the connecting contact, can be connected in addition to a ground connection (6).

2. Device according to claim 1, **characterised in that** each of the conductors (2) can be connected to a ground connection (6) via a respective switch (5).

3. Device according to claim 1 or 2, **characterised in that** the connection to the ground connection (6) takes place via at least one buffer member.

4. Device according to one of the preceding claims, **characterised in that** the switch (5) has at least three switched positions, in which case the associated conductor (2)
- is not connected to a ground connection (6) in a first switched position,
- is connected directly to the ground connection (6) in a second switched position and
- is connected to the ground connection (6) via at least one buffer member in a third switched position.

5. Device according to claim 3 or 4, **characterised in that** the buffer member comprises a capacitor (7) and a resistor (8).

## Revendications

1. Dispositif pour mesurer des composants électroniques, comprenant une pluralité de conducteurs (2) appliqués sur un porte-conducteurs (1) diélectrique, qui sont reliés chacun d'une part avec un doigt de contact (3) et d'autre part avec un contact de connexion (4) pour la liaison avec un dispositif de mesure, **caractérisé en ce que** dans au moins un des conducteurs (2) est intégré un commutateur (5) via lequel le conducteur (2) qui relie un des doigts de contact avec un contact de connexion est susceptible d'être relié entre le doigt de contact et le contact de connexion additionnellement avec un connecteur de masse (6).

2. Dispositif selon la revendication 1, **caractérisé en ce que** chacun des conducteurs (2) est susceptible d'être relié à un connecteur de masse (6) via un commutateur respectif (5).

3. Dispositif selon la revendication 1 ou 2, **caractérisé en ce que** la liaison avec le connecteur de masse (6) a lieu via au moins un élément tampon.

4. Dispositif selon l'une des revendications précédentes, **caractérisé en ce que** le commutateur (5) présente au moins trois positions de commutation, telles que le conducteur associé (2)
- n'est pas relié à une connexion de masse (6) dans une première position de commutation,
- est relié directement avec le connecteur de masse (6) dans une seconde position de commutation, et
- est relié au connecteur de masse (6) via au moins un élément tampon dans une troisième position de commutation.

5. Dispositif selon la revendication 3 ou 4, **caractérisé en ce que** l'élément tampon inclut un condensateur (7) et une résistance ohmique (8).
